(19) Europäisches Patentamt
European Patent Office
Office européen des brevets

(11) EP 0 616 258 B1

(12) **EUROPÄISCHE PATENTSCHRIFT**

(45) Veröffentlichungstag und Bekanntmachung des Hinweises auf die Patenterteilung:
**21.05.1997 Patentblatt 1997/21**

(51) Int Cl.$^6$: **G03F 7/004**, G03F 7/039

(21) Anmeldenummer: **94102859.9**

(22) Anmeldetag: **25.02.1994**

(54) **Strahlungsempfindliches Gemisch und Verfahren zur Herstellung von Reliefstrukturen mit verbessertem Kontrast**

Radiation sensitive composition and process for forming relief structures with improved contrast

Composition photosensible et procédé pour la formation d'une structure en relief ayant un contraste amélioré

(84) Benannte Vertragsstaaten:
**BE DE FR GB IT NL**

(30) Priorität: **01.03.1993 DE 4306069**

(43) Veröffentlichungstag der Anmeldung:
**21.09.1994 Patentblatt 1994/38**

(73) Patentinhaber: **BASF Aktiengesellschaft**
**67063 Ludwigshafen (DE)**

(72) Erfinder:
- **Funhoff, Dirk, Dr.**
  **D-69126 Heidelberg (DE)**
- **Schwalm, Reinhold, Dr.**
  **D-67157 Wachenheim (DE)**
- **Binder, Horst**
  **D-68623 Lampertheim (DE)**

(56) Entgegenhaltungen:
**EP-A- 0 141 400**
**EP-A- 0 472 029**
**EP-A- 0 540 965**
**US-A- 4 775 609**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 616 258 B1

## Beschreibung

Die Erfindung betrifft positiv arbeitende strahlungsempfindliche Gemische, die säurelabile Gruppierungen und photoaktive Komponenten enthalten, sensitiv gegenüber aktinischer Strahlung sind und deren Kontrast durch die Zugabe von starken Basen verbessert wird. Diese strahlungsempfindlichen Gemische eignen sich besonders als Resistmaterialien für Einlagenresiste zur Herstellung von Reliefmustern.

Insbesondere betrifft die Erfindung positiv arbeitende strahlungsempfindliche Gemische, die an sich bekannt sind und auf dem Prinzip der "chemischen Verstärkung" beruhen. Dabei wird in einer Primärphotoreaktion eine Spezies erzeugt, die dann unabhängig von der Strahlung eine katalytische Sekundärreaktion auslöst und dadurch die Empfindlichkeit drastisch erhöht. Solche Systeme, die photochemisch eine starke Säure erzeugen, die dann in einer Sekundärreaktion säurelabile Gruppen spalten, sind z.B. aus US-PS 3 923 514, US-PS 3 915 706 und DE-A 34 06 927 bekannt.

Der Kontrast derartiger Resiste, d.h. die "Schärfe" bei der Differenzierung zwischen unbelichteten und belichteten Bereichen ist eine wichtige anwendungstechnische Größe. Daher sind Verfahren zur Verbesserung des Kontrasts immer gesucht.

Aufgabe der vorliegenden Erfindung ist es, ein strahlungsempfindliches Gemisch aufzuzeigen, das bei seiner Verarbeitung zu Reliefstrukturen einen verbesserten Kontrast ergibt.

Diese Aufgabe läßt sich überraschenderweise bei positiv arbeitenden strahlungsempfindlichen Gemischen durch die Zugabe von starken Basen lösen.

Dies ist um so überraschender, als bekannt ist, daß bereits geringe Mengen an Basen aus der Luft die Abbildungsqualität deutlich beeinträchtigen (siehe z.B. S.A. MacDonald, N.J. Clecak, H.R. Wendt, C.G. Willson, C.D. Snyder, C. J. Knors, N.B. Deyoe, J.G. Maltabes, J.R. Morrow, A.E. McGuire and S.J. Holmes, Proc. SPIE 1466, 2 (1991); W.D. Hinsberg, S.A. MacDonald, N.J. Clecak and C.D. Synder, Proc. SPIE 1672, 24 (1992); O. Nalamasu, E. Reichmanis, M. Cheng, V. Pol, J.M. Kometani, F.M. Houlihan, T.X. Neenan, M.P. Bohrer, D.A. Mixon and L.F. Thompson, Proc. SPIE 1466, 13 (1991)). Es wird sogar in der US-A-4 775 609 die Verwendung von Basen zur Umkehrung von Positiv-Resisten empfahlen d.h. zur Herstellung von Negativ-Bildern von positiv arbeitenden Resisten, genau das Gegenteil, was normalerweise von einem positiv arbeitenden strahlungsempfindlichen Gemisch erwartet wird.

Gegenstand der vorliegenden Erfindung sind daher positiv arbeitende strahlungsempfindliche Gemische, im wesentlichen bestehend aus

(a1) einem säurelabile Gruppierungen enthaltenden, in Wasser unlöslichen organischen Bindemittel, das durch Einwirkung von Säure in wäßrig-alkalischen Lösungen löslich wird, oder

(a2.1) einem in Wasser unlöslichen, in wäßrig-alkalischen Lösungen löslichen polymeren Bindemittel und

(a2.2) einer organischen Verbindung, deren Löslichkeit in einem wäßrig-alkalischen Entwickler durch Einwirkung von Säure erhöht wird, und

(b) einer organischen Verbindung, welche unter Einwirkung von aktinischer Strahlung eine Säure erzeugt,

dadurch gekennzeichnet, daß zusätzlich

(c) mindestens eine stark basische organische Verbindung aus der Gruppe der quartären Ammoniumhydroxide, -alkoxide oder -phenoxide enthalten ist.

Komponente (c) ist im erfindungsgemäßen strahlungsempfindlichen Gemisch in Mengen von 0,01 bis 50, vorzugsweise 1 bis 20 mol-%, bezogen auf Komponente (b) enthalten.

Als Komponente (b) bevorzugt sind Sulfonium- oder Jodoniumsalze der allgemeinen Formeln (I) oder (II)

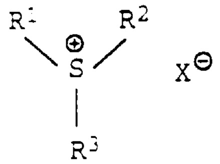

(I)

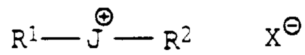

(II)

worin $R^1$, $R^2$ und $R^3$ untereinander gleich oder verschieden sind und für Alkyl, Oxaalkyl, Aryl, alkyl- oder alkoxysubstituiertes Aryl, Aralkyl oder den Rest

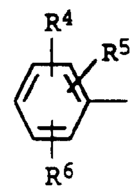

stehen, worin $R^4$, $R^5$ und $R^6$ untereinander gleich oder verschieden sind und für H, OH, Halogen, Alkyl oder Alkoxy stehen und $X^{\ominus}$ ein nichtnukleophiles Gegenion bedeutet.

Bevorzugt sind auch Sulfoniumsalze der allgemeinen Formel (III)

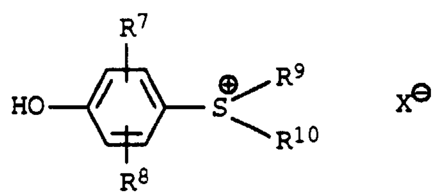

(III)

worin $R^7$ und $R^8$ untereinander gleich oder verschieden sind und für H, OH, Alkyl oder Alkoxy stehen, $R^9$ und $R^{10}$ untereinander gleich oder verschieden sind und für Alkylreste mit 1 bis 18 Kohlenstoffatomen stehen, und $X^{\ominus}$ ein nichtnukleophiles Gegenion bedeutet.

Als Komponente (b) bevorzugt sind auch Sulfoniumsalze der allgemeinen Formel (IV)

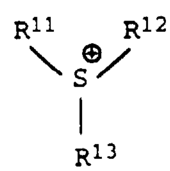

(IV)

worin $R^{11}$, $R^{12}$ und $R^{13}$ untereinander gleich oder verschieden sind und für Alkyl, Oxaalkyl, Aryl, alkyl- oder alkoxysubstituiertes Aryl oder Aralkyl stehen oder zwei der Reste $R^{11}$ bis $R^{13}$ miteinander zu einem Ring verknüpft sind, mit der Maßgabe, daß mindestens einer der Reste $R^{11}$ bis $R^{13}$ mindestens eine durch Säure spaltbare Gruppierung enthält, wobei einer der Reste $R^{11}$ bis $R^{13}$ mit einem oder mehreren weiteren Sulfoniumsalzresten, gegebenenfalls über durch Säure abspaltbare Gruppierungen, verknüpft sein kann, und $X^{\ominus}$ ein nichtnukleophiles Gegenion bedeutet.

Die Komponenten (a1) bzw. (a2.1) und (a2.2) können säurelabile Ether-, Ester-, Acetal-, Ketal- oder Carbonatgruppen enthalten.

Als Komponente (a1) oder (a2.1) können insbesondere Polymere oder Copolymere verwendet werden, die als Monomereinheiten t-Butoxystyrol, t-Butoxycarbonyloxystyrol, Tetrahydropyranyloxystyrol, t-Butyldimethylsilyloxystyrol, Trimethylsilyloxystyrol oder 4-Methoxytetrahydropyranyloxystyrol enthalten.

Als Komponenten (a1) oder (a2.1) kommen vorzugsweise auch solche Polymeren oder Copolymeren in Betracht, die sowohl phenolische Einheiten als auch nichtaromatische cyclische Alkoholeinheiten (mit p-Hydroxycyclohexylresten) enthalten, wobei weiter bevorzugt ist, daß in den Polymeren oder Copolymeren die phenolischen Einheiten gegenüber den nichtaromatischen cyclischen Alkoholeinheiten überwiegen.

Insbesondere kommen hier die von der Fa. MARUZEN kommerziell erhältlichen Polyvinylphenole (Lyncur PHM-C Typen) in Frage, welche nachträglich hydriert sind. Diese Polymeren können dann in polymeranalogen Reaktionen so umgesetzt werden, daß die phenolischen Gruppen ganz oder teilweise durch säurelabile Ether-, Ester-, Acetal-,

Ketal- oder Carbonatgruppen ersetzt sind.

Die erfindungsgemäßen strahlungsempfindlichen Gemische können als Komponente (b) auch einen Sulfonsäureester, insbesondere einen Alkylsulfonsäureester einer Verbindung mit mindestens zwei phenolischen Hydroxylgruppen oder ein Disulfon enthalten.

Die erfindungsgemäßen strahlungsempfindlichen Gemische enthalten Komponente (a) in einer Menge von 80 bis 99,5 Gew.-% und Komponente (b) in einer Menge von 0,5 bis 20 Gew.-%, bezogen auf die Gesamtmenge der Komponenten (a) und (b), und können zusätzlich bis zu 2 Gew.-% eines Haftvermittlers, Tensids oder Farbstoffs oder einen Sensibilisator, der Strahlung absorbiert und auf Komponente (b) überträgt, enthalten.

Gegenstand der vorliegenden Erfindung ist auch ein Verfahren zur Herstellung lichtempfindlicher Beschichtungsmaterialien unter Einsatz des erfindungsgemäßen strahlungsempfindlichen Gemisches sowie ein Verfahren zur Herstellung von Reliefstrukturen durch Auftragen eines erfindungsgemäßen strahlungsempfindlichen Gemisches in einer Schichtdicke von 0,1 bis 5 µm auf ein in üblicher Weise vorbehandeltes Substrat, Trocknen bei Temperaturen von 70 bis 140°C, bildmäßiges Belichten, gegebenenfalls Erhitzen auf Temperaturen von 40 bis 160°C, und Entwickeln mit einer wäßrigalkalischen Lösung.

Mit dem erfindungsgemäßen strahlungsempfindlichen Gemisch lassen sich Reliefstrukturen mit wesentlich verbessertem Kontrast herstellen. Hervorzuheben ist außerdem die hohe Empfindlichkeit, gute Auflösung und leichte Verarbeitbarkeit des erfindungsgemäßen strahlungsempfindlichen Gemisches.

Zu den Aufbaukomponenten des erfindungsgemäßen strahlungsempfindlichen Gemisches ist im einzelnen folgendes auszuführen.

Als erfindungsgemäß wirkende, stark basische organische Verbindungen (c) kommen solche mit Hydroxy-, Alkoxy- oder Phenoxy-Anionen in Frage. Diese Verbindungen basieren z.B. auf quartären Ammoniumsalzen, deren Anionen entweder Hydroxid, Alkoxid oder Phenoxid sind. Als Kation der quartären Ammoniumsalze werden alle gleich oder verschieden substituierte Tetralkylammonium-Derivate bevorzugt wie z.B. Tetramethyl-, Tetraethyl-, Tetra-n-propyl-, Tetra-n-butyl-, Vinyltrimethyl-, Hexadecyltrimethylammonium und Trimethyl-(2-hydroxyethyl)-ammoniumhydroxid. Ebenfalls bevorzugt werden aromatische Gruppen enthaltende quartäre Ammoniumsalze wie z.B. Benzyltrimethylammonium- oder Phenyltrimethylammoniumsalze. Als spezifische Verbindungen werden Tetramethylammoniumhydroxid, Tetraethylammoniumhydroxid, Tetra-n-propylammoniumhydroxid, Tetra-n-butylammoniumhydroxid, Vinyltrimethylammoniumhydroxid, Hexadecyltrimethylammoniumhydroxid, Benzyltrimethylammoniumhydroxid, Benzyltrimethylammoniummethanolat, Tetra-n-decylammoniumhydroxid, Cetylbenzyldimethylammoniumhydroxid, Tetra-n-hexylammoniumhydroxid, Tetra-n-octylammoniumhydroxid, Tributylmethylammoniumhydroxid, Triethylphenylammoniumhydroxid, N-Ethyl-N-dodecyl-N,N-dimethylammoniumhydroxid, Benzyl-triethylammoniumhydroxid oder Phenyltrimethylammoniumhydroxid bevorzugt.

Alle organischen Basen mit einem $pK_b$ von < 2,5 lassen sich erfindungsgemäß anwenden. Gemische der erfindungsgemäß einzusetzenden starken Basen können ebenfalls verwendet werden.

Die Komponente (c) ist in 0.01 - 50 mol-%, bevorzugt 1 - 20 mol-% bezogen auf Komponente (b) im erfindungsgemäßen strahlungsempfindlichen Gemisch enthalten.

In den erfindungsgemäßen strahlungsempfindlichen Gemischen können als Komponente (a1) alle üblichen säurelabile Gruppierungen enthaltenden, in Wasser unlöslichen organischen Bindemittel verwendet werden, deren Löslichkeit in wäßrig-alkalischen Entwicklern durch Einwirkung von Säure zunimmt.

Als verwendbare säurelabile Gruppen sind insbesondere Ether-, Ester-, Acetal-, Ketal- oder Carbonatgruppen zu erwähnen. Bevorzugt dabei sind Ether wie t-Butoxyether, Trimethylsilylether oder t-Butyldimethylsilylether, Acetale wie Tetrahydropyranylether, sowie Ketale wie 4-Methoxy-tetrahydroypyranylether und 1-Methyl-1-methoxyethylether.

Als in Wasser unlösliche organische Bindemittel (a1), deren Löslichkeit in wäßrig-alkalischen Entwicklern durch Einwirkung von Säure zunimmt, kommen insbesondere Polymere bzw. Copolymere in Frage, die als Monomereinheiten 4-Hydroxystyrol, 2,6-Dimethyl-4-hydroxystyrol, 2-Methyl-4-hydroxystyrol, 4-Hydroxy-alphamethylstyrol, t-Butoxystyrol, t-Butoxycarbonyloxystyrol, hydropyranyloxystyrol, t-Butyldimethyl-silyloxystyrol, silyloxystyrol oder 4-Methoxytetrahydropyranyloxystyrol enthalten. Als Comonomeren kommen darüber hinaus alle mit Styrol copolymerisierbaren Monomere, wie z.B. Acrylate, Methacrylate, Schwefeldioxid und Maleinimide, in Betracht.

Bevorzugt sind auch solche Polymere bzw. Copolymere (a1), die sowohl phenolische Einheiten als auch nichtaromatische cyclische Alkoholeinheiten enthalten, insbesondere solche Polymere, in denen die phenolischen Einheiten gegenüber den nichtaromatischen cyclischen Alkoholeinheiten überwiegen. Derartige Produkte sind beispielsweise in EP-A-0 401 499 bzw. in EP-A-0 543 324 beschrieben.

Das polymere Bindemittel (a1) ist im erfindungsgemäßen Gemisch im allgemeinen in einer Menge von 80 bis 99,5, vorzugsweise von 90 bis 99 Gew.-%, bezogen auf die Gesamtmenge der Komponenten (a1) und (b), enthalten. Die Molekulargewichte ($\bar{M}_w$) dieser Homo- bzw. Copolymere liegen zwischen 2000 und 100000, bevorzugt zwischen 4000 und 35000.

Besonders bevorzugt sind darüber hinaus alle derartigen Bindemittel, die in DE-A-4 007 924 und DE-A-4 202 845 beschrieben sind.

Als in Wasser unlösliche, in wäßrig-alkalischen Lösungen lösliche polymere Bindemittel (a2.1) kommen Polymere auf Basis von Homo- oder Copolymeren des 4-Hydroxystyrols und/oder 4-Hydroxy-alphamethylstyrols in Betracht, wobei als Comonomereinheiten besonders in o-Stellung zur Hydroxygruppe mono- oder disubstituierte Hydroxystyrole oder Hydroxystyrole, deren phenolische Gruppe mit säurelabilen Gruppierungen geschützt ist, in Frage kommen. Besonders bevorzugte säurelabile Gruppierungen sind dabei Ether wie t-Butoxyether, Trimethylsilylether oder t-Butyldimethylsilylether, Acetale wie Tetrahydropyranyl-ether, Ester, wie t.-Butyl-ester, sowie Ketale, wie 4-Methoxy-tetrahydroypyranylether und 1-Methyl-1-methoxyethyl-ether. Diese säurelabile Gruppierungen enthaltenden Comonomereinheiten sind dabei nur in solchen Mengen vorhanden; daß das polymere Bindemittel (a2.1) wäßrig alkalisch löslich ist. Im allgemeinen werden dazu Bereiche von 5 - 50 mol-% bevorzugt.

Bevorzugt sind wiederum auch solche polymere Bindemittel (a2.1), die sowohl phenolische Einheiten als auch nichtaromatische Alkoholeinheiten enthalten, insbesondere solche Polymere, in welchen die phenolischen Einheiten gegenüber den nichtaromatischen Alkoholeinheiten überwiegen. Geeignete Produkte können beispielsweise auch der EP-A-0 534 324 entnommen werden.

Die Polymeren (a2.1) weisen ein Molekulargewicht ($\bar{M}_w$) zwischen 2000 und 100000, vorzugsweise zwischen 4000 und 30000 auf.

Als organische Verbindungen (a2.2), welche säurelabile Gruppen enthalten, seien hier beispielshaft aufgeführt:

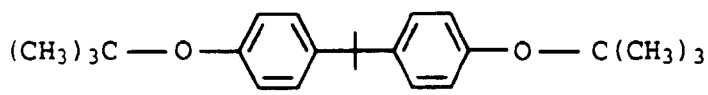
,

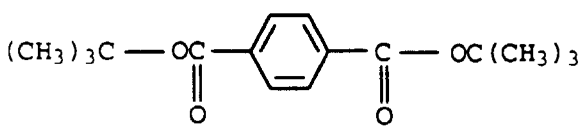
,

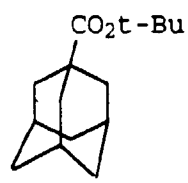

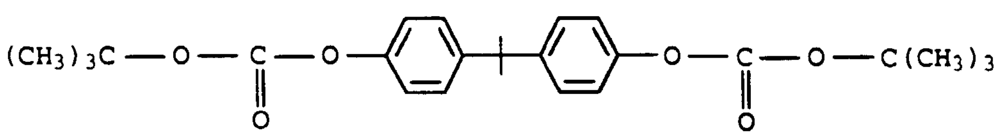
,

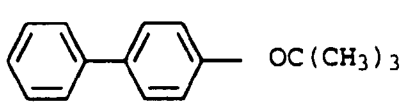
,
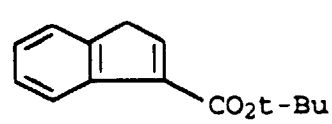

und

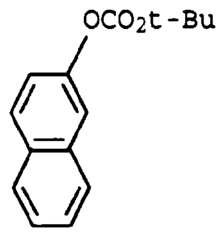

Brauchbar sind auch nichtpolymere Verbindungen, die mindestens ein aromatisches Ringsystem mit einem oder mehreren pyranyloxysubstituenten gemäß der EP-A-0 475 903 aufweisen, spielsweise:

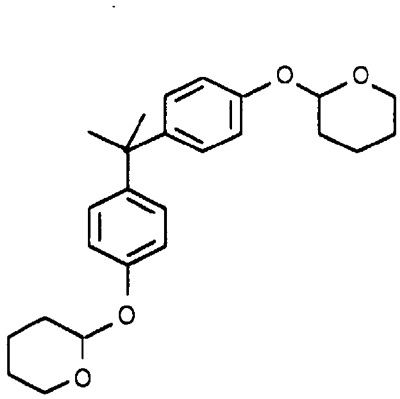

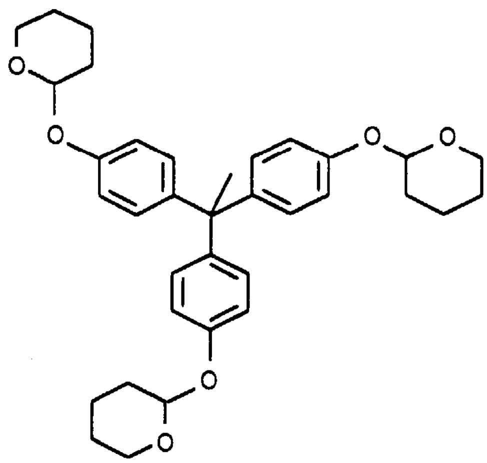

Als organische Verbindungen, welche unter Einwirkung von aktinischer Strahlung eine Säure erzeugen (= Säurespender) (b), kommen alle dem Fachmann bekannten photochemischen Säurespender in Frage.

Bevorzugt sind Sulfonium- oder Jodoniumsalze der allgemeinen Formel (I) oder (II),

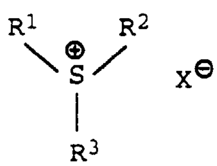

(I)

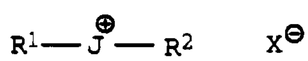

(II)

worin $R^1$, $R^2$ oder $R^3$ untereinander gleich oder verschieden sind und für geradkettig oder verzweigtes Alkyl mit 1 bis 18, vorzugsweise 1 bis 6 Kohlenstoffatomen, wie z.B. Methyl, Ethyl, n-Propyl, Isopropyl, n-Butyl, Isobutyl, tert.-Butyl, Hexyl, Oxaalkyl mit bis zu 3 Sauerstoffatomen und bis zu 10 Kohlenstoffatomen, Aryl mit 6 bis 12 Kohlenstoffatomen, wie z.B. Phenyl oder Naphthyl, $C_1$ bis $C_6$-alkyl- oder $C_1$ bis $C_6$-alkoxysübstituiertes Aryl, Aralkyl, wie z.B. Benzyl, oder den Rest

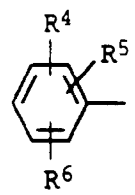

stehen, worin $R^4$, $R^5$ und $R^6$ untereinander gleich oder verschieden sind und für H, OH, Halogen, Alkyl mit 1 bis 18, vorzugsweise 1 bis 6 Kohlenstoffatomen, wie z.B. Methyl, Ethyl, n-Propyl, Isopropyl, n-Butyl, Isobutyl, tert.-Butyl, Hexyl, oder Alkoxy mit 1 bis 6 Kohlenstoffatomen, wie z.B. Methoxy, Ethoxy, Propoxy, Butoxy stehen, und $X^{\ominus}$ ein nicht-nukleophiles Gegenion bedeutet.

Beispiele für gut geeignete Komponenten (b) nach den allgemeinen Formeln (I) bzw. (II) sind Triphenylsulfoniumsalze und Diphenyliodoniumsalze sowie Tris-(4-hydroxyphenyl)sulfoniumsalze und Bis-(4-hydroxyphenyl)iodoniumsalze.

Besonders gut geeignete Sulfoniumsalze besitzen die allgemeine Formel (III)

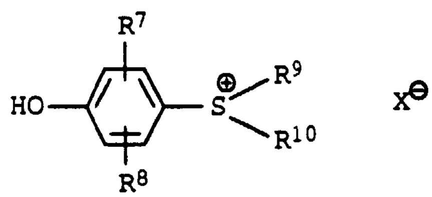

(III)

worin $R^7$ und $R^8$ untereinander gleich oder verschieden sind und für H, OH, Alkyl mit 1 bis 18, vorzugsweise 1 bis 6 Kohlenstoffatomen, wie z.B. Methyl, Ethyl, n-Propyl, Isopropyl, n-Butyl, Isobutyl, tert.-Butyl, Hexyl,oder Alkoxy mit 1 bis 6 Kohlenstoffatomen, wie z.B. Methoxy, Ethoxy, Propoxy, Butoxy stehen, $R^9$ und $R^{10}$ untereinander gleich oder verschieden sind und für Alkylreste mit 1 bis 18 Kohlenstoffatomen stehen und $X^{\ominus}$ ein nicht-nukleophiles Gegenion bedeutet.

Beispiele besonders vorteilhafter Sulfoniumsalze sind 4-Hydroxyphenyl-dimethylsulfonium- und 3,5-Dimethyl-4-hydroxyphenyl-dimethylsulfoniumsalze. Beispiele gut geeigneter, nicht-nukleophiler Anionen sind komplexe Metallhalogenide wie Tetrafluoroborat, Hexafluoroantimonat, Hexafluoroarsenat und starke organische Säureanionen wie Trifluormethansulfonat und Fluorsulfonat.

Hervorzuheben sind auch die Sulfoniumsalze der allgemeinen Formel (IV),

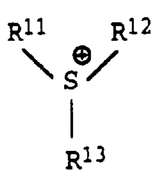

(IV)

worin $R^{11}$, $R^{12}$ und $R^{13}$ untereinander gleich oder verschieden sind und für aliphatische und/oder aromatische Reste, die gegebenenfalls Heteroatome enthalten, stehen oder zwei der Reste $R^{11}$ bis $R^{13}$ miteinander zu einem Ring verknüpft sind, mit der Maßgabe, daß mindestens einer der Reste $R^{11}$ bis $R^{13}$ mindestens eine durch Säure spaltbare Gruppierung, vorzugsweise t-Butylcarbonate von Phenolen bzw. Silylether von Phenolen enthält, wobei einer der Reste $R^{11}$ bis $R^{13}$ mit einem oder mehreren weiteren Sulfoniumsalzresten, gegebenenfalls über durch Säure spaltbare Gruppierungen, verknüpft sein kann, und $X^{\ominus}$ ein nicht-nukleophiles Gegenion bedeutet.

Als Gegenionen kommen bevorzugt komplexe Metallhalogenide, wie Tetrafluoroborat, Hexafluoroantimonat, Hexafluoroarsenat und starke organische Säureanionen wie Trifluormethansulfonat (= Triflat) und Fluorsulfonat in Frage.

Es können auch zwei oder mehrere Sulfoniumeinheiten im Molekül über die Reste $R^{11}$ bis $R^{12}$ verknüpft sein.

Bevorzugte Sulfoniumsalze der allgemeinen Formel (IV) sind solche, in denen $R^{11}$ und $R^{12}$ für Methylgruppen und $R^{13}$ für substituierte Phenylderivate mit säurespaltbaren Gruppen stehen, z.B.

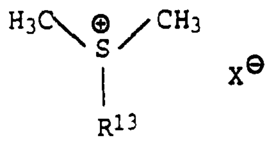

worin $R^{13}$ z.B. für 4-t-Butoxycarbonyloxyphenyl-, 4-t-Butoxycarbonyloxy-3,5-dimethylphenyl, 4-t-Butoxycarbonyloxy-3-methyl-phenyl-, 4-t-Butoxycarbonyloxy-2-methyl-phenyl-, 4-t-Butoxycarbonyloxy-3,5-dimethoxyphenyl, 4-t-Butoxicarbonyloxy-3,5-dimethylphenyl-, 1-t-Butoxycarbonyloxy-naphthyl-, 4-Trimethylsilyl-oxyphenyl, 4-Trimethylsilyl-oxy-napththyl- stehen oder auch solche, in denen zwei der Reste $R^{11}$ bis $R^{13}$ miteinander zu einem Ring, insbesondere einem fünf- oder sechsgliedrigen Ring verknüpft sind, wobei z.B. $R^{11}$ und $R^{12}$ beispielsweise zu Tetramethylengruppen verbrückt sind und $R^{13}$ die gleiche Bedeutung wie vorstehend hat:

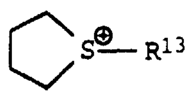

oder Verbindungen, in denen $R^{11}$ für Methyl und $R^{12}$ für Phenyl bzw. Tolyl stehen und $R^{13}$ für ein substituiertes Phenylderivat mit säurespaltbaren Gruppen steht, worin $R^{13}$, für 4-t-Butoxycarbonyloxy-phenyl-, 2,4-Di-t-butoxycarbonyloxy-phenyl-, 4-t-Butoxycarbonyloxy-2-methoxy-phenyl, 4-Trimethylsilylphenyl- steht, oder worin $R^{11}$ für Phenyl oder $C_1$- bis $C_{12}$-alkyl-substituiertes Phenyl oder halogensubstituiertes Phenyl steht und $R^{12}$ und $R^{13}$ substituierte Phenylderivate mit säurespaltbaren Gruppen sind, worin $R^{12}$ und $R^{13}$ z.B. 4-t-Butoxycarbonyloxy-phenyl, 4-Trimethylsilyloxyphenyl, 4-t-Butyl-dimethylsilyloxyphenyl-, 4-t-Butoxycarbonyloxy-3,5-dimethylphenyl- oder $R^{11}$, $R^{12}$ und $R^{13}$ untereinander gleich sind, d.h. Sulfoniumsalze, in denen diese Reste mit säurespaltbaren Gruppen dreimal enthalten sind.

Bevorzugte Beispiele für Verbindungen (b) sind Dimethyl-4-t-butoxycarbonyloxy-phenyl-sulfoniumsalze mit Hexafluoroarsenat, Hexafluoroantimonat, Hexafluorophosphat, Hexafluoroborat oder Trifluormethansulfonat als Gegenion, Phenyl-(bis-(4-t-butoxycarbonyloxyphenyl-)sulfoniumsalz mit den genannten Gegenionen, Tris-(4-t-butoxycarbonyloxyphenyl-)sulfoniumsalz mit den genannten Gegenionen oder 1-Naphthyl-4-trimethylsilyloxytetramethylensulfoniumsalze mit den genannten Gegenionen.

Ebenfalls bevorzugt werden als Komponente (b) Alkylsulfonsäureester von Verbindungen, die mindestens zwei phenolische Hydroxy-Gruppen enthalten. Beispiele besonders gut geeigneter Substanzen sind 1,2,3-Tris-(methansulfonyloxy)benzol und 1,3-Bis-(methansulfonyloxy)benzol oder Disulfone wie z.B. Diphenyldisulfon, 4-Methoxyphenyl-phenyldisulfon oder Bis-(4-hydroxyphenyl)disulfon.

Auch Gemische der unter (b) genannten Verbindungen mit sich selbst oder anderen, hier nicht explizit aufgeführten organischen photochemischen Säurespendern können eingesetzt werden. Die Menge der Summe aller Komponenten (b) beträgt im erfindungsgemäßen strahlungsempfindlichen Gemisch im allgemeinen 0,5 bis 20, vorzugsweise 1 bis 10 Gew.-%, bezogen auf die Summe aller Komponenten (a) und (b) im strahlungsempfindlichen Gemisch.

Das erfindungsgemäße strahlungsempfindliche Gemisch kann zusätzlich noch weitere, dem Stand der Technik entsprechende, übliche Hilfs- und Zusatzstoffe (Sensibilisatoren, Farbstoffe, Verlaufshilfsmittel, Netzhilfsmittel, Stabilisatoren usw.) enthalten. Diese Zusatzstoffe werden im allgemeinen in Mengen kleiner 3 Gew.-% zugesetzt.

Die erfindungsgemäßen Gemische werden zur Herstellung von Resists bevorzugt in einem organischen Lösungsmittel gelöst, wobei der Feststoffgehalt üblicherweise im Bereich zwischen 5 und 40 Gew.-% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethylcellosolve, Butylglykol, Methylcellosolve und 1-Methoxy-2-propanol, Alkylenglykolalkylether-ester, wie beispielsweise Methylcellosolveacetat, Methylpropylenglykolacetat und Ethylpropylenglykolacetat, Ketone, wie beispielsweise Cyclohexanon, Cyclopentanon und Methylethylketon, sowie Acetate wie Butylacetat, Ethylacetat, andere Ester, wie Ethyllactat und Butyrolacton sowie Aromaten wie Toluol und Xylol. Die Auswahl der entsprechenden Lösungsmittel, sowie deren Mischungen richtet sich nach der Wahl der jeweiligen Komponenten des strahlungsempfindlichen Gemischs.

Weiterhin können andere Zusätze wie Haftvermittler und Weichmacher zugesetzt werden, im allgemeinen in Mengen von bis zu 1 Gew.-%.

Die erfindungsgemäßen strahlungsempfindlichen Gemische sind sensitiv gegenüber Röntgen-, Elektronen- und DV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen.

Bei dem erfindungsgemäßen Verfahren zur Herstellung von positiven Reliefmustern wird eine strahlungsempfindliche Aufzeichnungsdie im wesentlichen aus dem erfindungsgemäßen lungsempfindlichen Gemisch besteht, bildmäßig in solcher Dosis bestrahlt, daß die Löslichkeit der belichteten Bereiche nach einem thermischen Ausheizschritt bei Temperaturen zwischen 40 und 160°C in wäßrig-alkalischen Lösungsmitteln zunimmt und diese Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 140°C) und mit einer geeigneten Lichtquelle durch eine Photomaske bildmäßig belichtet, z.B. mit kurzwelligen UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 160°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 10 und 300 mJ/cm$^2$ bei Schichtdicken von 1 µm.

Die erfindungsgemäßen strahlungsempfindlichen Gemische zeichnen sich durch hohe Empfindlichkeit, gute Auflösung und leichte Verarbeitbarkeit aus und eignen sich daher besonders vorteilhaft für die Lithographie im kurzwelligen Bereich.

Die erfindungsgemäßen strahlungsempfindlichen Gemische mit dem Zusatz starker Basen (c) zeichnen sich gegenüber denjenigen ohne den Zusatz von (c) durch einen verbesserten Kontrast aus.

Die in den Beispielen genannten Teile und Prozente sind, soweit nicht anders angegeben, Gewichtsteile bzw. Gewichtsprozente.

Beispiel 1

Eine Photoresistlösung wurde aus 5 Teilen Triphenylsulfoniumtriflat, 95 Teilen Poly-[4-hydroxystyrol-co-4-t-Butyldimethylsilyloxystyrol] (molares Verhältnis der Comonomeren 7:3) und 300 Teilen 1-Methoxy-2-propanol hergestellt. Dazu wurden 5 mol-% Tetra-n-butylammoniumhydroxid, bezogen auf die Menge an Triphenylsulfoniumtriflat gegeben. Durch ein Filter mit einem Porendurchmesser von 0,2 µm wurde diese Lösung anschließend filtriert.

Von dieser Lösung wurde eine ca. 1 µm dicke Schicht auf oberflächlich oxidierte Siliziumwafer aufgeschleudert und 1 min bei 90°C ausgeheizt. Nach der Belichtung durch eine strukturierte Testmaske mit Excimer-Laserlicht der Wellenlänge 248 nm wurde dieser Wafer bei 70°C für 1 min ausgeheizt und mit einem wäßrig-alkalischen Entwickler (pH 12 - 13) 1 min entwickelt.

Der Kontrast des Resists, ausgedrückt mittels des Gamma-Werts ($\Gamma_p$), wurde aus einer Auftragung von Schichtdicke gegen Belichtungsdosis ermittelt. Für Positiv-Resistsysteme ist der Gamma-Wert definiert als

$$\Gamma_p = [\log \frac{D_1}{D_0}]^{-1}$$

wobei $D_0$ und $D_1$ die extrapolierten Belichtungsenergiedosen aus der Dunkelabtragsenergiekurve darstellen.

Es ergab sich ein Gamma-Wert $\Gamma_p = 7{,}3$.

Beispiel 2

Es wurde analog zu Beispiel 1 verfahren, mit der Abweichung, daß 10 mol-% Tetra-n-butylammoniumhydroxid, bezogen auf die Menge an Triphenylsulfoniumtriflat, zugegeben wurden.

Es ergab sich ein Gamma-Wert $\Gamma_p = 7{,}8$.

Beispiel 3

Eine Photoresistlösung wurde aus 7 Teilen Tris-(4-t-Butoxycarbonyloxyphenyl)-sulfoniumtriflat, 93 Teilen Poly-[4-hydroxystyrol-co-4-t-Butoxycarbonyloxystyrol] (molares Verhältnis der Comonomeren 7,5:2,5) und 350 Teilen Methoxypropylacetat hergestellt. Dazu wurden 5 mol-% Tetra-n-butylammoniumhydroxid, bezogen auf die Menge an Tris-(4-t-Butoxycarbonyloxyphenyl)-sulfoniumtriflat, gegeben.

Nach analoger Behandlung wie in Beispiel 1 - aber nach der Belichtung bei 90°C ausgeheizt - wurde ein Gamma-Wert $\Gamma_p$ = 9,5 gemessen.

Beispiel 4

Es wurde wie in Beispiel 3 verfahren, jedoch wurden 10 mol-% Tetra-n-butylammoniumhydroxid, bezogen auf die Menge an Tris-(4-t-Butoxycarbonyloxy-phenyl)-sulfoniumtriflat zugegeben.

Es ergab sich ein Gamma-Wert $\Gamma_p$ = 9,6.

Beispiel 5

Aus 4 Teilen 4-Hydroxyphenyl-dimethylsulfoniumtriflat, 96 Teilen Poly-[4-hydroxystyrol-co-4-tetrahydropyranyloxystyrol (molares Verhältnis der Comonomeren 7:3) und 300 Teilen Ethyllactat wurde eine Photoresistlösung hergestellt. Dazu wurden 3 mol-% methylammoniumhydroxid, bezogen auf die Menge an 4-Hydroxyphenyl-dimethylsulfoniumtriflat gegeben.

Nach analoger Behandlung wie in Beispiel 3 ergab sich ein Gamma-Wert $\Gamma_p$ = 6,8.

Beispiel 6

Analog zu Beispiel 5 wird die dort beschriebene Photoresistlösung mit 20 mol-% Tetramethylammoniumhydroxid versetzt, es ergibt sich ein Gamma-Wert $\Gamma_p$ = 7,9.

Beispiel 7

Eine Photoresistlösung wurde aus 2 Teilen Tris-(4-t-Butoxycarbonyloxyphenyl)-sulfoniumtriflat, 3 Teilen Tris-(methansulfonyloxy)benzol, 95 Teilen Poly-[4-hydroxystyrol-co-4-t-Butoxycarbonyloxystyrol] (molares Verhältnis der Comonomeren 7,5:2,5) und 300 Teilen Methoxypropylacetat hergestellt. Dazu wurden 5 mol-% Tetramethylammoniumhydroxid, bezogen auf die Menge an Tris-(4-t-Butoxycarbonyloxyphenyl)-sulfoniumtriflat, gegeben.

Nach analoger Behandlung wie in Beispiel 3 wurde ein Gamma-Wert $\Gamma_p$ = 6,5 gemessen.

Beispiel 8

Analog zu Beispiel 7 wird die dort beschriebene Photoresistlösung mit 10 mol-% Tetramethylammoniumhydroxid versetzt, es ergibt sich ein Gamma-Wert $\Gamma_p$ = 6,5.

Beispiel 9

Eine Photoresistlösung wurde aus 4 Teilen Tris-(4-hydroxyphenyl)-sulfoniumtriflat, 96 Teilen Poly-[4-hydroxystyrol-co-4-Trimethylsilyloxystyrol] (molares Verhältnis der Comonomeren 7:3) und 300 Teilen Ethyllactat hergestellt. Dazu wurden 5 mol-% methylammoniummethanolat, bezogen auf die Menge an Tris-(4-hydroxyphenyl)-sulfoniumtriflat, gegeben.

Nach analoger Behandlung wie in Beispiel 3 wurde ein Gamma-Wert $\Gamma_p$ = 7,5 gemessen.

Beispiel 10

Analog zu Beispiel 9 wird die dort beschriebene Photoresistlösung mit 10 mol-% Benzyltrimethylammoniummethanolat versetzt, es ergibt sich ein Gamma-Wert $\Gamma_p$ = 7,3.

Vergleichsbeispiel 1

Eine Photoresistlösung wurde aus 5 Teilen Triphenylsulfoniumtriflat, 95 Teilen Poly-[4-hydroxystyrol-co-4-t-Butyldimethylsilyloxystyrol] (molares Verhältnis der Comonomeren 7:3) und 300 Teilen 1-Methoxy-2-propanol hergestellt.

Nach analoger Behandlung wie in Beispiel 1 ergab sich ein Gamma-Wert $\Gamma_p$ = 3,5.

Vergleichsbeispiel 2

Eine Photoresistlösung wurde aus 7 Teilen Tris-(4-t-Butoxycarbonyloxyphenyl)-sulfoniumtriflat, 93 Teilen Poly-[4-hydroxystyrol-co-4-t-Butoxycarbonyloxystyrol] (molares Verhältnis der Comonomeren 7,5:2,5) und 350 Teilen Methoxypropylacetat hergestellt.
Nach analoger Behandlung wie in Beispiel 3 ergab sich ein Gamma-Wert $\Gamma_p$ = 4,9.

Vergleichsbeispiel 3

Aus 4 Teilen 4-Hydroxyphenyl-dimethylsulfoniumtriflat, 96 Teilen Poly-[4-hydroxystyrol-co-4-tetrahydropyranyloxystyrol] (molares Verhältnis der Comonomeren 7:3) und 300 Teilen Ethyllactat wurde eine Photoresistlösung hergestellt.

Nach analoger Behandlung wie in Beispiel 5 ergab sich ein Gamma-Wert $\Gamma_p$ = 3,7.

Vergleichsbeispiel 4

Eine Photoresistlösung wurde aus 2 Teilen Tris-(4-t-Butoxycarbonyloxyphenyl)-sulfoniumtriflat, 3 Teilen Tris-(methansulfonyloxy)benzol, 95 Teilen Poly-[4-hydroxystyrol-co-4-t-Butoxycarbonyloxystyrol] (molares Verhältnis der Comonomeren 7,5:2,5) und 300 Teilen Methoxypropylacetat hergestellt.

Nach analoger Behandlung wie in Beispiel 7 ergab sich ein Gamma-Wert $\Gamma_p$ = 2,5.

Vergleichsbeispiel 5

Eine Photoresistlösung wurde aus 4 Teilen Tris-(4-hydroxyphenyl)sulfoniumtriflat, 96 Teilen Poly-[4-hydroxystyrol-co-4-Trimethylsilyloxystyrol] (molares Verhältnis der Comonomeren 7:3) und 300 Teilen Ethyllactat hergestellt.

Nach analoger Behandlung wie in Beispiel 9 ergab sich ein Gamma-Wert $\Gamma_p$ = 4,0.

Beispiel 11

Ein Polymer, das sowohl phenolische Einheiten als auch nichtaromatische cyclische Alkoholeinheiten enthält (z. B. Polyvinylphenol der Fa. MARUZEN mit der Bezeichnung Maruka Lyncur PHM-C; Molekulargewicht 5000 ± 500; Hydriergrad max. 18 %), wurde mit Dihydropyran so umgesetzt, daß ca. 40 % der phenolischen OH-Gruppen Tetrahydropyraneinheiten enthalten. Aus 96 Teilen des so hergestellten Polymeren, 4 Teilen 4-Hydroxyphenyl-dimethylsulfoniumtriflat und 300 Teilen Ethyllactat wurde eine resistlösung hergestellt. Dazu wurden 2 mol-% ammoniumhydroxid, bezogen auf die Menge an 4-Hydroxyphenyldimethylsulfoniumtriflat, gegeben.

Nach analoger Behandlung wie in Beispiel 3 wurde ein Gamma-Wert $\Gamma_p$ von 7,6 gemessen.

**Patentansprüche**

**1.** Positiv arbeitende strahlungsempfindliche Gemische, im wesentlichen bestehend aus

(a1) einem saurelabile Gruppierungen enthaltenden, in Wasser unlöslichen organischen Bindemittel, das durch Einwirkung von Säure in wäßrig-alkalischen Lösungen löslich wird, oder

(a2.1) einem in Wasser unlöslichen, in wäßrig-alkalischen Lösungen löslichen polymeren Bindemittel und

(a2.2) einer organischen Verbindung, deren Löslichkeit in einem wäßrig-alkalischen Entwickler durch Einwirkung von Säure erhöht wird, und

(b) einer organischen Verbindung, welche unter Einwirkung von aktinischer Strahlung eine Säure erzeugt,

dadurch gekennzeichnet, daß zusätzlich
(c) mindestens eine stark basische organische Verbindung aus der Gruppe der quartären Ammoniumhydroxide, -alkoxide oder -phenoxide enthalten ist.

2. Strahlungsempfindliches Gemisch nach Anspruch 1, dadurch gekennzeichnet, daß Komponente (c) in einer Menge von 0,01 - 50 mol-%, bezogen auf Komponente (b), enthalten ist.

3. Strahlungsempfindliches Gemisch nach einem der Ansprüche 1 oder 2 dadurch gekennzeichnet, daß als Komponente (b) Sulfonium- oder Iodoniumsalze der allgemeinen Formel (I) oder (II)

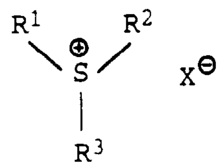

(I)

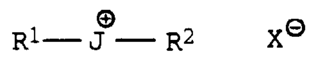

(II)

eingesetzt werden, worin $R^1$, $R^2$ und $R^3$ untereinander gleich oder verschieden sind und für Alkyl, Oxaalkyl, Aryl, alkyl- oder alkoxysubstituiertes Aryl, oder den Rest

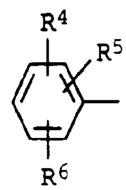

stehen, worin $R^4$, $R^5$ und $R^6$ untereinander gleich oder verschieden sind und für H, OH, Halogen, Alkyl oder Alkoxy stehen und $X^\ominus$ ein nicht-nukleophiles Gegenion bedeutet.

4. Strahlungsempfindliches Gemisch nach einem der Ansprüche 1 oder 2, dadurch gekennzeichnet, daß als Komponente (b) Sulfoniumsalze der allgemeinen Formel (III)

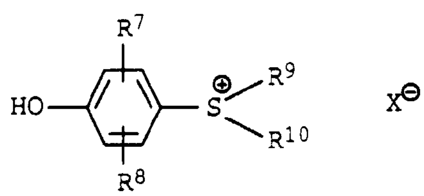

(III)

eingesetzt werden,
worin $R^7$ und $R^8$ untereinander gleich oder verschieden sind und für H, OH, Alkyl oder Alkoxy stehen, $R^9$ und $R^{10}$ untereinander gleich oder verschieden sind und für Alkylreste mit 1 bis 18 Kohlenstoffatomen stehen und $Y^\ominus$ ein nicht-nukleophiles Gegenion bedeutet.

5. Strahlungsempfindliches Gemisch nach einem der Ansprüche 1 oder 2, dadurch gekennzeichnet, daß als Komponente (b) Sulfoniumsalze der allgemeinen Formel (IV)

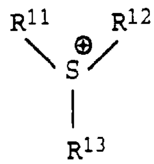

(IV)

verwendet werden, worin $R^{11}$, $R^{12}$ und $R^{13}$ untereinander gleich oder verschieden sind und für Alkyl, Oxaalkyl, Aryl, alkyl- oder alkoxysubstituiertes Aryl oder Aralkyl stehen, oder zwei der Reste $R^{11}$ bis $R^{13}$ miteinander zu einem Ring verknüpft sind, mit der Maßgabe, daß mindestens einer der Reste $R^{11}$ bis $R^{13}$ mindestens eine durch Säure spaltbare Gruppierung enthält, wobei einer der Reste $R^{11}$ bis $R^{13}$ mit einem oder mehreren weiteren Sulfoniumsalzresten, gegebenenfalls über durch Säure abspaltbare Gruppierungen, verknüpft sein kann, und $X^{\ominus}$ ein nicht-nukleophiles Gegenion bedeutet.

**6.** Strahlungsempfindliches Gemisch nach einem der Ansprüche 1 bis 5, dadurch gekennzeichnet, daß die Komponenten (al) bzw. (a2.1) und (a2.2) säurelabile Ether-, Ester-, Acetal-, Ketal- oder Carbonatgruppen enthalten.

**7.** Strahlungsempfindliches Gemisch nach einem der Ansprüche 1 bis 6, dadurch gekennzeichnet, daß als Komponente (al) oder (a2.1) Polymere oder Copolymere verwendet werden, die als Monomereinheiten t-Butoxystyrol, t-Butoxycarbonyloxystyrol, Tetrahydropyranyloxystyrol, t-Butyldimethylsilyloxystyrol, Trimethylsilyloxystyrol oder 4-Methoxytetrahydropyranyloxystyrol enthalten.

**8.** Strahlungsempfindliches Gemisch nach einem der Ansprüche 1 bis 7, dadurch gekennzeichnet, daß als Komponente (al) oder (a2.1) solche Polymere oder Copolymere eingesetzt werden, die phenolische Einheiten und nichtaromatische cyclische Alkoholeinheiten enthalten.

**9.** Strahlungsempfindliches Gemisch nach Anspruch 8, dadurch gekennzeichnet, daß in den Polymeren oder Copolymeren die phenolischen Einheiten gegenüber den nichtaromatischen cyclischen Alkoholeinheiten überwiegen.

**10.** Strahlungsempfindliches Gemisch nach einem der Ansprüche 1 bis 9, dadurch gekennzeichnet, daß als Komponente (b) ein Sulfonsäureester enthalten ist.

**11.** Strahlungsempfindliches Gemisch nach einem der Ansprüche 1 bis 9, dadurch gekennzeichnet, daß als Komponente (b) ein Alkylsulfonsäureester einer Verbindung mit mindestens zwei phenolischen Hydroxylgruppen enthalten ist.

**12.** Strahlungsempfindliches Gemisch nach einem der Ansprüche 1 bis 9, dadurch gekennzeichnet, daß als Komponente (b) ein Disulfon enthalten ist.

**13.** Strahlungsempfindliches Gemisch nach einem der Ansprüche 1 bis 9, dadurch gekennzeichnet, daß Komponente (a) in einer Menge von 80 bis 99,5 Gew.% und Komponente (b) in einer Menge von 0,5 bis 20 Gew.-%, bezogen auf die Gesamtmenge der Komponenten (a) und (b), enthalten ist.

**14.** Strahlungsempfindliches Gemisch nach einem der vorhergehenden Ansprüche, dadurch gekennzeichnet, daß es zusätzlich bis zu 2 Gew.-% eines Haftvermittlers, Tensids oder Farbstoffs enthält.

**15.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**16.** Verfahren zur Herstellung lichtempfindlicher Beschichtungsmaterialien, dadurch gekennzeichnet, daß ein strahlungsempfindliches Gemisch gemäß einem der Ansprüche 1 bis 15 eingesetzt wird.

**17.** Verfahren zur Herstellung von Reliefstrukturen durch Auftragen eines strahlungsempfindlichen Gemischs in einer Schichtdicke von 0,1 bis 5 μm auf ein in üblicher Weise vorbehandeltes Substrat, Trocknen bei Temperaturen von 70 bis 140°C, bildmäßiges Belichten, gegebenenfalls Erhitzen auf Temperaturen von 40 bis 160°C, und Entwickeln mit einer wäßrig-alkalischen Lösung, dadurch gekennzeichnet, daß ein strahlungsempfindliches Gemisch gemäß einem der Ansprüche 1 bis 15 eingesetzt wird.

**Claims**

**1.** A positive-working radiation-sensitive mixture, essentially consisting of

(a1) a water-insoluble organic binder which contains acid-labile groups and is rendered soluble in aqueous alkaline solutions by the action of an acid, or
(a2.1) a polymeric binder which is insoluble in water but soluble in aqueous alkaline solutions and
(a2.2) an organic compound whose solubility in an aqueous alkaline developer is increased by the action of an acid, and
(b) an organic compound which produces an acid under the action of actinic radiation,

wherein
(c) at least one strongly basic organic compound selected from the group consisting of quaternary ammonium hydroxides, alkoxides and phenoxides is additionally present.

**2.** A radiation-sensitive mixture as claimed in claim 1, wherein component (c) is present in an amount of from 0.01 to 50 mol %, based on component (b).

**3.** A radiation-sensitive mixture as claimed in claim 1 or 2, wherein component (b) used is a sulfonium or iodonium salt of the formula (I) or (II)

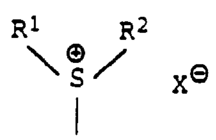
(I)

$$R^1\text{-}J^{\oplus}\text{-}R^2\ X^{\ominus} \qquad (II)$$

where $R^1$, $R^2$ and $R^3$ are identical or different and are each alkyl, oxaalkyl, aryl, alkyl- or alkoxy-substituted aryl or a radical

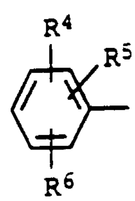

where $R^4$, $R^5$ and $R^6$ are identical or different and are each H, OH, halogen, alkyl or alkoxy and $X^{\ominus}$ is a nonnucleophilic counter-ion.

**4.** A radiation-sensitive mixture as claimed in claim 1 or 2, wherein component (b) used is a sulfonium salt of the formula (III)

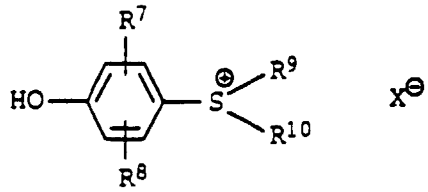

(III)

where $R^7$ and $R^8$ are identical or different and are each H, OH, alkyl or alkoxy, $R^9$ and $R^{10}$ are identical or different and are each alkyl of 1 to 18 carbon atoms and $X^{\ominus}$ is a nonnucleophilic counter-ion.

**5.** A radiation-sensitive mixture as claimed in claim 1 or 2, wherein component (b) used is a sulfonium salt of the formula (IV)

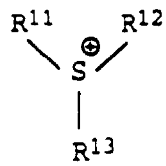

(IV)

where $R^{11}$, $R^{12}$ and $R^{13}$ are identical or different and are each alkyl, oxaalkyl, aryl or alkyl-substituted or alkoxy-substituted aryl or aralkyl, or two of the radicals $R^{11}$ to $R^{13}$ are bonded to one another to form a ring, with the proviso that at least one of the radicals $R^{11}$ to $R^{13}$ contains at least one acid-cleavable group, it being possible for one of the radicals $R^{11}$ to $R^{13}$ to be bonded, if necessary via acid-cleavable groups, to one or more further sulfonium salt radicals, and $X^{\ominus}$ is a nonnucleophilic counter-ion.

**6.** A radiation-sensitive mixture as claimed in any of claims 1 to 5, wherein the components (a1) or (a2.1) and (a2.2) contain acid-labile ether, ester, acetal, ketal or carbonate groups.

**7.** A radiation-sensitive mixture as claimed in any of claims 1 to 6, wherein polymers or copolymers which contain, as monomer units, tert-butoxystyrene, tert-butoxycarbonyloxystyrene, tetrahydropyranyloxystyrene, tert-butyldimethylsilyloxystyrene, trimethylsilyloxystyrene or 4-methoxytetrahydropyranyloxystyrene are used as component (a1) or (a2.1).

**8.** A radiation-sensitive mixture as claimed in any of claims 1 to 7, wherein polymers or copolymers containing both phenolic units and nonaromatic cyclic alcohol units are used as component (al) or (a2.1).

**9.** A radiation-sensitive mixture as claimed in claim 8, wherein the phenolic units in the polymers or copolymers outnumber the nonaromatic cyclic alcohol units.

**10.** A radiation-sensitive mixture as claimed in any of claims 1 to 9, wherein a sulfonate is present as component (b).

**11.** A radiation-sensitive mixture as claimed in any of claims 1 to 9, wherein an alkylsulfonate of a compound having at least two phenolic hydroxyl groups is present as component (b).

**12.** A radiation-sensitive mixture as claimed in any of claims 1 to 9, wherein a disulfone is present as component (b).

**13.** A radiation-sensitive mixture as claimed in any of claims 1 to 9, wherein component (a) is present in an amount of from 80 to 99.5% by weight and component (b) is present in an amount of from 0.5 to 20% by weight, based on

the total amount of components (a) and (b).

**14.** A radiation-sensitive mixture as claimed in any of the preceding claims, which additionally contains up to 2% by weight of an adhesion promoter, of a surfactant or a colorant.

**15.** A radiation-sensitive mixture as claimed in any of the preceding claims, which additionally contains a sensitizer which absorbs radiation and transmits it to component (b).

**16.** A process for the preparation of a photosensitive coating material, wherein a radiation-sensitive mixture as claimed in any of claims 1 to 15 is used.

**17.** A process for the production of relief structures by application of a radiation-sensitive mixture in a layer thickness of from 0.1 to 5 µm to a substrate pretreated in a conventional manner, drying at from 70 to 140°C, imagewise exposure, if necessary heating to 40-160°C, and development with an aqueous alkaline solution, wherein a radiation-sensitive mixture as claimed in any of claims 1 to 15 is used.

**Revendications**

**1.** Mélange photosensible pour image positive, consistant essentiellement en

(a1) un liant organique insoluble dans l'eau, contenant des groupements instables en présence d'acides, qui est soluble dans des solutions alcalines aqueuses sous l'action d'un acide, ou

(a2.1) un liant polymère insoluble dans l'eau, soluble dans des solutions alcalines aqueuses et

(a2.2) un composé organique, dont la solubilité dans un révélateur alcalin aqueux est augmentée par l'action d'un acide, et

(b) un composé organique, qui produit un acide sous l'action d'un rayonnement actinique,

caractérisés par le fait qu'il comprend en outre
(c) au moins un composé organique fortement basique choisi dans le groupe des hydroxydes, alcoxydes ou phénoxydes d'ammonium quaternaire.

**2.** Mélange photosensible selon la revendication 1, caractérisé par le fait que le composant (c) est présent en une quantité de 0,01 - 50 % en mol, par rapport au composant (b).

**3.** Mélange photosensible selon l'une des revendications 1 ou 2, caractérisé par le fait que sont utilisés comme composant (b) des sels de sulfonium ou d'iodonium de formule générale (I) ou (II)

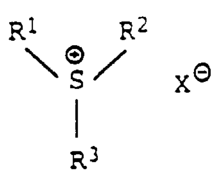

(I)

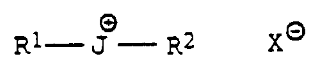

(II)

où $R^1$, $R^2$ et $R^3$ sont identiques entre eux ou différents et représentent des groupes oxaalkyle, aryle, aryle substitué par un radical alkyle ou alcoxy, ou le reste

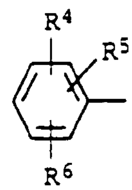

où $R^4$, $R^5$ et $R^6$ sont identiques entre eux ou différents et représentent des radicaux H, OH, halogéno, alkyle ou alcoxy et $X^{\ominus}$ désigne un contre-ion non-nucléophile.

4. Mélange photosensible selon l'une des revendications 1 ou 2, caractérisé par le fait que sont utilisés comme composant (b) des sels de sulfonium de formule générale (III)

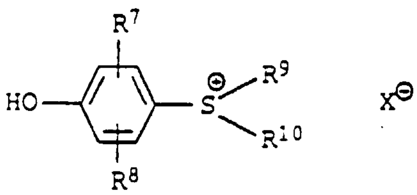

(III)

où $R^7$ et $R^8$ sont identiques entre eux ou différents et désignent des radicaux H, OH, alkyle ou alcoxy, $R^9$ et $R^{10}$ sont identiques entre eux ou différents et désignent des restes alkyle ayant 1 à 18 atomes de carbone et $X^{\ominus}$ représente un contre-ion non-nucléophile.

5. Mélange photosensible selon l'une des revendications 1 ou 2, caractérisé par le fait que sont utilisés comme composant (b) des sels de sulfonium de formule générale (IV)

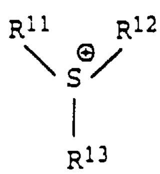

(IV)

où $R^{11}$, $R^{12}$ et $R^{13}$ sont identiques entre eux ou différents et désignent des radicaux alkyle, oxaalkyle, aryle, aryle ou aralkyle substitué par un radical alkyle ou alcoxy, ou deux des restes $R^{11}$ à $R^{13}$ sont réunis entre eux pour former un cycle, avec pour condition qu'au moins l'un des restes $R^{11}$ à $R^{13}$ contient au moins un groupement éliminable par un acide, tandis qu'un des restes $R^{11}$ à $R^{13}$ peut être lié à un ou plusieurs autres restes de sel de sulfonium, éventuellement par l'intermédiaire de groupements éliminables par des acides, et $X^{\ominus}$ représente un contre-ion non-nucléophile.

6. Mélange photosensible selon l'une quelconque des revendications 1 à 5, caractérisé par le fait que les composants respectivement (al) ou (a2.1) et (a2.2) contiennent des groupes éther, ester, acétal, cétal ou carbonate instables en présence d'acides.

**7.** Mélange photosensible selon l'une quelconque des revendications 1 à 6, caractérisé par le fait que sont utilisés comme composant (a1) ou (a2.1) des polymères ou copolymères qui contiennent comme unités monomères du t-butoxystyrène, du t-butoxycarbonyloxystyrène, du tétrahydropyrannyloxystyrène, du t-butyldiméthylsilyloxystyrène, du triméthylsilyloxystyrène ou du 4-méthoxytétrahydropyrannyloxystyrène.

**8.** Mélange photosensible selon l'une quelconque des revendications 1 à 7, caractérisé par le fait que sont utilisés comme composant (al) ou (a2.1) des polymères ou copolymères qui contiennent des unités phénoliques et des unités alcool cyclique non-aromatique.

**9.** Mélange photosensible selon la revendication 8, caractérisé par le fait que dans les polymères ou copolymères les unités phénoliques sont en excès par rapport aux unités alcool cyclique non-aromatique.

**10.** Mélange photosensible selon l'une quelconque des revendications 1 à 9, caractérisé par le fait qu'il contient comme composant (b) un ester d'acide sulfonique.

**11.** Mélange photosensible selon l'une quelconque des revendications 1 à 9, caractérisé par le fait qu'il contient comme composant (b) un ester d'acide alkylsulfonique d'un composé ayant au moins deux groupes hydroxy phénoliques.

**12.** Mélange photosensible selon l'une quelconque des revendications 1 à 9, caractérisé par le fait qu'il contient comme composant (b) une disulfone.

**13.** Mélange photosensible selon l'une quelconque des revendications 1 à 9, caractérisé par le fait que le composant (a) est contenu en une quantité de 80 à 99,5 % en poids et le composant (b) en une quantité de 0,5 à 20 % en poids, par rapport à la quantité totale des composants (a) et (b).

**14.** Mélange photosensible selon l'une quelconque des revendications précédentes, caractérisé par le fait qu'il contient en outre jusqu'à 2 % en poids d'un adjuvant de fixation, d'un agent de surface ou d'un colorant.

**15.** Mélange photosensible selon l'une quelconque des revendications précédentes, caractérisé par le fait qu'il contient en outre un sensibilisateur qui absorbe le rayonnement et le transfère sur le composant (b).

**16.** Procédé pour la préparation de matières d'enduction sensibles à la lumière, caractérisé par le fait qu'on utilise un mélange photosensible selon l'une quelconque des revendications 1 à 15.

**17.** Procédé pour la préparation de structures en relief par dépôt d'un mélange photosensible dans une épaisseur de couche de 0,1 à 5 μm sur un substrat prétraité de manière classique, séchage à des températures de 70 à 140°C, éclairement selon une image, éventuellement chauffage à des températures de 40 à 160°C, et développement avec une solution alcaline aqueuse, caractérisé par le fait qu'on utilise un mélange photosensible selon l'une quelconque des revendications 1 à 15.